# EUROPÄISCHE PATENTSCHRIFT

(11) **EP 0 666 934 B1**
(45) Veröffentlichungstag und Bekanntmachung des Hinweises auf die Patenterteilung: **26.03.1997**
(21) Anmeldenummer: 93918891.8
(22) Anmeldetag: 18.08.1993
(51) Int. Cl.: C23C 14/54, C23C 14/32

(54) **VERFAHREN ZUM PLASMAGESTÜTZTEN REAKTIVEN ELEKTRONENSTRAHLBEDAMPFEN**
PLASMA-ASSISTED REACTIVE ELECTRON-JET VAPORISATION PROCESS
PROCEDE DE VAPORISATION REACTIVE PAR JET ELECTRONIQUE, ASSISTEE PAR PLASMA

(30) Priorität: 27.10.1992 DE 4236264
(43) Veröffentlichungstag der Anmeldung: 16.08.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHILLER, Siegfried, D-01324 Dresden (DE); KIRCHHOFF, Volker, D-01324 Dresden (DE); ZEISSIG, Gerhard, D-01069 Dresden (DE); SCHILLER, Nicolas, D-01833 Helmsdorf (DE); GOEDICKE, Klaus, D-01307 Dresden (DE); NEUMANN, Manfred, D-01277 Dresden (DE)
(86) Internationale Anmeldenummer: DE9300748
(87) Internationale Veröffentlichungsnummer: WO9410356

(56) Entgegenhaltungen:
- US-A- 4 024 291
- US-A- 5 128 007

## Beschreibung

Die Erfindung betrifft ein Verfahren zum plasmagestützten reaktiven Elektronenstrahlbedampfen, insbesondere Hochratebedampfen, vorzugsweise für die Erzeugung verschleißarmer, harter Schichten und Barriereschichten. Derartige Schichten bestehen beispielsweise aus Metalloxiden und dienen als Kratz- und Verschleißschutzschichten auf Glas, Kunststoff oder auch anderem Material. Sie finden u. a. für Fassadenglas und in der Bauindustrie Anwendung. Die Barrierewirkung von Schichten ist vorzugsweise in der Verpackungsindustrie von großer Bedeutung, um dieses Material zum Beispiel sauerstoff- und wasserdampfundurchlässig zu machen. Barriereschichten sind auch für den Korrosionsschutz von Bedeutung und werden dort angewendet.

Eine Grundvoraussetzung für die Herstellung der genannten Schicht im technischen Maßstab ist es, während der gesamten Beschichtungszeit konstante Schichteigenschaften zu gewährleisten. Diese Bedingung stellt hohe Anforderungen an das Verfahren zum Aufdampfen der Schichten, da es sich in der Regel um hochproduktive Anlagen mit hoher Durchlaufgeschwindigkeit und großer Substratfläche handelt. Unter den Bedingungen der Hochratebeschichtung sind Schwankungen der Prozeßparameter unvermeidbar. Es ist bekannt, beim Elektronenstrahlbedampfen über den gesamten Bedampfungszeitraum bestimmte Schichteigenschaften zu monitorieren. Dazu dienen die optischen Eigenschaften, z. B. Transmission und Reflexion, und die elektrischen Eigenschaften, wie Leitfähigkeit, die in-situ meßbar sind. Dazu ist bekannt, daß die beschichtete Folie unmittelbar nach dem Bedampfungsprozeß ein Meßwalzensystem passiert, durch das mittels Messung des elektrischen Leitwertes die Schichtdickenverteilung bestimmt wird. Durch Regelung der Aufenthaltszeiten des Elektronenstrahls an verschiedenen Stellen des Verdampfungsgutes wird die Schichtdickenverteilung gezielt eingestellt [S. Schiller et al; Proceedings of the 2nd Int. Conference cn Vakuum Web Coating, Fort Lauder dale, Florida, USA, Oct. 1988].
Es ist weiterhin bekannt, zur Bestimmung der optischen Eigenschaften die Transmission bzw. die Reflexion optischer Schichten im interessierenden Wellenlängenbereich zu bestimmen und daraus den Farbort oder andere applikative optische Eigenschaften zu berechnen. Ein gängiges Verfahren ist es auch, aus der Transparenz oder Reflexion die Schichtdicke in-situ zu bestimmen [G. Whitehead; P. Grant; The Optical Monitor; Proc. 28th Ann. Techn. Conf. Soc. Vac. Coaters; Philadelphia 1985, S. 109-115]. Es kann aus der Messung der Reflexions- und Absorptionsspektren der Brechungsindex bestimmt werden. Für die oben genannten Einsatzgebiete der zu beschichtenden Substrate bzw. Materialien sind dagegen die mechanischen Eigenschaften, wie Härte, Abrieb und Barrierewirkung, von Bedeutung. Zur direkten Messung solcher Eigenschaften gibt es verschiedene Meßverfahren [K. Nitzsche; Schichtmeßtechnik, VEB Deutscher Verlag für Grundstoffindustrie, Leipzig 1974]. Diese sind jedoch alle nicht zur in-situ-Messung geeignet.
Die mechanischen Eigenschaften hängen im starken Maße von der inneren Schichtstruktur und -zusammensetzung ab. Beim Elektronenstrahl-Hochratebedampfen ist eine Konstanz der genannten Eigenschaften durch die komplexe Abhängigkeit von den Abscheidebedingungen von Natur aus nicht gegeben. Die Struktur und Zusammensetzung der abgeschiedenen Schichten müssen deshalb notwendigerweise, zumindest auf direktem Wege, in-situ gemessen und geregelt werden, um die geforderten mechanischen Eigenschaften konstant zu halten.

Der Erfindung liegt die Aufgabe zugrunde, ein Verfahren zum plasmagestützten reaktiven Elektronenstrahlbedampfen zu schaffen, mit welchem bestimmte nichtoptische Schichteigenschaften, insbesondere mechanische Eigenschaften, in-situ gemessen werden können, um Schichten mit hoher Konstanz bei hoher Produktivität reproduzierbar aufbringen zu können. Es sollen die in bekannter Weise gewonnenen Werte der Reflexion und/oder Transmission und optischen Absorption bei Wellenlängen von 150 bis 800 nm als Signal zur Regelung mit verarbeitet werden. Das Verfahren soll in Durchlaufanlagen besonders für die Herstellung verschleißarmer, harter Schichten oder Schichten mit Barrierewirkung geeignet sein. Es sollen Meßgrößen gefunden werden, die in-situ zerstörungsfrei ermittelbar sind. Es sollen geeignete, ggf. auch bekannte Regelmöglichkeiten für die Prozeßführung eingesetzt werden.

Erfindungsgemäß wird die Aufgabe nach den Merkmalen des Anspruches 1 gelöst. Weitere Ausgestaltungen des Verfahrens zeigen die Unteransprüche.

Es wurde überraschenderweise gefunden, daß bestimmte nichtoptische Eigenschaften, wie beispielsweise die Härte, der Abrieb und die Barrierewirkung, von Schichten mit bestimmten optischen Eigenschaften, wie Absorption, Reflexion und Transmission, korrelieren. Offensichtlich ist diese Abhängigkeit darin begründet, daß sich Änderungen in der Packungsdichte, der chemischen Zusammensetzung und den Bindungszuständen sowohl bei den mechanischen und Barriereeigenschaften als auch bei den optischen Eigenschaften im gleichen Sinne auswirken. Es hat sich gezeigt, daß die Toleranzgrenzen der mechanischen und Barriereeigenschaften immer dann eingehalten werden, wenn die optischen Eigenschaften in bestimmten Toleranzgrenzen konstant gehalten werden. Dazu werden der Brechungsindex n und der Absorptionskoeffizient k überwacht. Weiterhin hat sich gezeigt, daß bei solchen plasmagestützten reaktiven Prozessen neben vielen anderen Parametern, die man experimentell ermitteln und konstant halten muß, die Reaktivgaspartialdrücke und die Plasmaparameter großen Einfluß auf diese Eigenschaften haben. Für den Schichtbildungsprozeß spielen die Reaktivität und die Bildungsenthalpie der chemischen Verbindung, aber auch das Dissoziationsvermögen bei der Elektronenstrahlverdampfung eine wichtige Rolle. Es ist prinzipiell möglich, den Reaktivgaspartialdruck oder die Plasmaparameter in Abhängigkeit von den in-situ gemessenen Werten n und k zu regeln, um die erzielten Schichteigenschaften zu erreichen. Es hat sich gezeigt, daß die Effektivität des gewählten Regelprozesses vom Schichtsystem abhängig ist. So ist z. B. bei der Abscheidung von SiOₓ-Schichten eine Regelung des Partialdruckes des Reaktivgases zur Erreichung konstanter Barriereeigenschaften besonderes effektiv. Demgegenüber hat sich bei der Abscheidung von Aluminiumoxid die Regelung der Plasmaparameter vorteilhaft erwiesen, um die geforderten mechanischen Eigenschaften, wie Härte und Abrieb, zu sichern.
Die Ermittlung des Brechungsindexes n und des Absorptionskoeffizienten k ist aber im Bereich des Plasmaraumes und damit unmittelbar während der Schichtbildung bei der Hochratebedampfung technisch nicht möglich. Daraus ergibt sich naturgemäß eine Zeitverzögerung zwischen Schichtbildung und der Bestimmung von n und k. Bedingt durch diese Zeitverzögerung ist daher eine bestimmte Grundstabilität des gesamten Bedampfungsprozesses erforderlich, damit gewährleistet ist, daß die Schichteigenschaften die geforderten Toleranzen nicht überschreiten.
Die erforderliche Plasmaanregung kann in bekannter Weise unter anderem durch Ionenquellen oder durch elektronenstoßbestinmte Niederdruckplasmen erfolgen. Als Voraussetzung für eine effektive Regelung des Reaktivgaspartialdruckes muß die Plasmaanregung während des Beschichtungsprozesses konstant gehalten werden. Es sind zur Konstanthaltung der Plasmaparameter verschiedene Regelverfahren bekannt, die auf der Messung der Plasmaparameter, beispielsweise mittels Sonden bzw. optischer Emissionsspektroskopie, beruhen. Zur Lösung der vorliegenden Aufgabe hat sich die Messung der optischen Plasmaemission als besonders vorteilhaft erwiesen.
Bei der Regelung der Plasmaparameter in Abhängigkeit von n und k muß der Reaktivgaspartialdruck konstant gehalten werden. Dazu ist es möglich, den Reaktivgasfluß oder die Saugleistung der Pumpen in Abhängigkeit vom Reaktivgaspartialdruck zu regeln.

Anhand von zwei Ausführungsbeispielen wird die Erfindung näher erläutert. In den zugehörigen Zeichnungen zeigen:

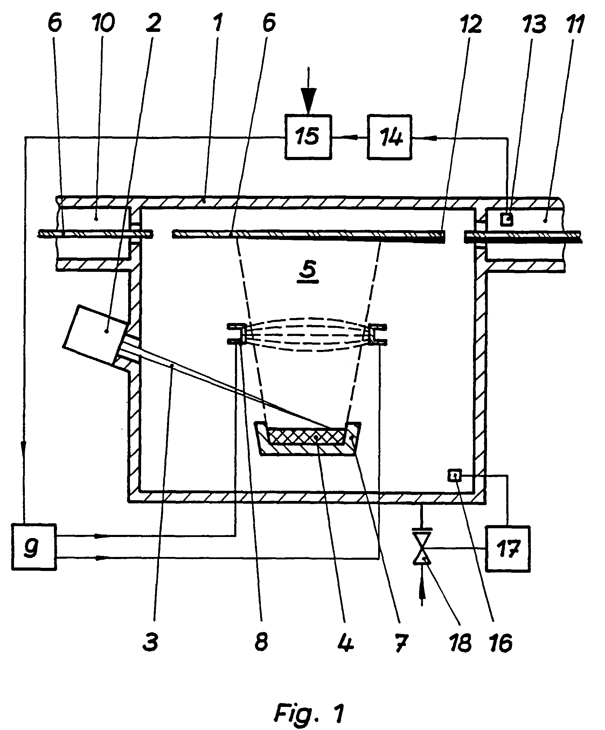

Fig. 1: eine Elektronenstrahl-Bedampfungseinrichtung zum Beschichten plattenförmiger Substrate
Fig. 2: eine Elektronenstrahl-Bedampfungseinrichtung zum Beschichten von Kunststoffolien

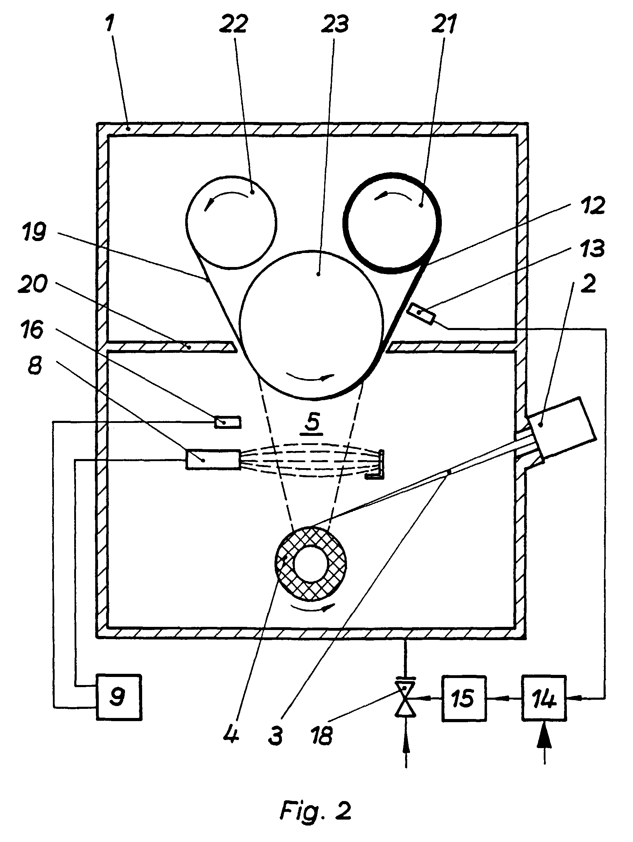

An die Bedampfungskamner 1 ist eine Elektronenkanone 2 vom Axialtyp mit Strahlführungssystem angeflanscht. Der mit der Elektronenkanone 2 erzeugte Elektronenstrahl 3 trifft unter programmierter Ablenkung auf die Oberfläche des Verdampfungsgutes 4 und erzeugt einen hohen Dampfdruck im Prozeßraum 5 (Bedampfungszone) zwischen dieser Oberfläche und einem darüber angeordneten zu bedampfenden plattenförmigen Substrat 6. Die Leistung der Elektronenkanone 2 beträgt 40 bis 50 kW. Als Verdampfungsgut 4, welches sich in einem Verdampfertiegel 7 befindet, dient Aluminiumoxid (Al₂O₃). Eine Plasmaquelle 8 befindet sich zwischen dem Verdampfertiegel 7 und dem Substrat 6 und dient zur Anregung des Dampfes. Die Plasmaquelle 8 wird durch den Plasmagenerator 9 gesteuert. Die Transportgeschwindigkeit des Substrates 6 beträgt ca. 1 m/s. Die Substratbewegung erfolgt über die Eingangsschleuse 10 durch die Bedampfungskammer 1 zur Meßkammer 11, aus welcher die Substrate 6 in bekannter Weise wieder ausgeschleust werden. Ziel des Bedampfungsprozesses ist die Abscheidung einer Schicht 12 auf dem Substrat 6 mit einer "statischen" Abscheidegeschwindigkeit von 0,5 µm/s. Die Schicht 12 soll eine hohe Härte und Abriebfestigkeit besitzen. Im technischen Betrieb ist es ohne Prozeßregelung unvermeidbar, daß eine Reihe von Störgrößen zu Instabilitäten des Prozesses und damit zur Abweichung der Schichteigenschaften von den angestrebten Parametern der Schicht 12 führen. Solche Störgrößen sind im Verdampfungsprozeß selbst, in der Stabilität der Plasmaanregung, wie auch in einer Beeinflussung des Dampfes bei der Ausbreitung im Prozeßraum 5 begründet. Sie sind nicht vollständig aufgeklärt und lassen sich mehrheitlich nicht beeinflussen. Beim vorliegenden Prozeß der Aluminiumoxidverdampfung entstehen z. B. lokale Krater an der Oberfläche des Verdampfungsgutes 4. Beobachtet werden auch Gasausbrüche bei der Dissoziation des Verdampfungsgutes 4, die zu Störungen der Dampfausbreitung führen. Die Beschichtung des gesamten Prozeßraumes, wie auch der darin angeordneten Plasmaquelle 6, läßt sich nicht vermeiden und führt zu Langzeitdriften verschiedener, nicht getrennt erfaßbarer Verdampfungsparameter und damit zu unerwünschten Änderungen der Schichteigenschaften.
Das erfindungsgemäße Verfahren mit dem Ziel der Herstellung von Schichten mit konstanten mechanischen Eigenschaften, wie Härte und Abrieb, wird mit der beschriebenen Einrichtung wie folgt ausgeführt:
Mittels eines in der Meßkammer 11 angeordneten Sensors 13 werden die Transmissionsspektren der Schicht 12 in einem Wellenlängenbereich von 200 bis 800 nm aufgenommen. In einer bekannten Auswerteeinheit 14 werden aus den gemessenen Spektren der Absorptionskoeffizient k und Brechungsindex n bestimmt und aus vorher experimentell ermittelten Zusammenhängen die mechanische Härte und Abriebfestigkeit abgeleitet. Diese Werte werden an einen Regler 15 gegeben und in diesem mit an sich bekannten Mitteln mit vorgegebenen Sollwerten verglichen. Die Sollwerte wurden experimentell ermittelt und repräsentieren die geforderte Abriebfestigkeit und Härte der aufgedampften Aluminiumoxidschicht 12 auf dem Substrat 6. Aus dem Vergleich dieser Werte wird ein Regelsignal gebildet und an den Plasmagenerator 9 geleitet, der in Abhängigkeit von diesem Regelsignal die Plasmaquelle 8 zur Änderung der Plasmaparameter beeinflußt.
Bei einem Abstand von 3 m zwischen der Mitte des Prozeßraumes 5 und dem Sensor 13 in der Meßkammer 11 und einer Transportgeschwindigkeit von 1 m/s ergibt sich eine Zeitverzögerung zwischen Schichtabscheidung und Eigenschaftsmessung von ca. 3 s. Diese Anordnung erfordert eine Grundstabilität des Beschichtungsprozesses über Zeiträume großer als 3 s. Um dies zu erreichen wird mit einem weiteren Sensor 16 und einem Partialdruckregler 17 über die Gaseinlaßeinrichtung 18 der Reaktivgaspartialdruck konstant gehalten. Bei der Anwendung dieses Verfahrens werden unter den angegebenen Prozeßbedingungen Toleranzen für die Härte von ± 10 % und den Abrieb von ± 20 % erreicht.
Mit der Einrichtung nach Fig. 2 werden Folien 19 (Polyesterfolie) bedampft. Die Bedampfung erfolgt nach dem bekannten "inneren" Durchlaufprinzip, wobei die Einrichtung eine Chargenanlage ist. In der Bedampfungskammer 1 befinden sich in bekannter Weise im oberen Teil, durch eine Trennwand 20 abgeteilt, der Aufwickel 21 und Abwickel 22 für die Folie 19, die über eine Kühlwalze 23 läuft. An die Bedampfungskammer 1 ist die Elektronenkanone 2 angeflanscht, deren Elektronenstrahl 3 auf das Verdampfungsgut 4 programmiert gelenkt wird. Das Verdampfungsgut 4 ist hierbei ein sich ständig um seine Längsachse drehendes Rohr aus Siliziumdioxid (SiO₂). Die Leistung der Elektronenkanone 2 beträgt 25 bis 30 kW. Die Plasmaquelle 8 befindet sich zwischen dem Verdampfungsgut 4 und der Folie 19 und dient zur Anregung des Dampfes. Die Plasmaquelle 8 wird über den Plasmagenerator 9 gesteuert. Die Transportgeschwindigkeit der Folie 19 beträgt 4 m/s. Die Bewegung der Folie 19 erfolgt vom Abwickel 22 durch den Prozeßraum 5 zum Aufwickel 21. Ziel des Elektronenstrahlbedampfens ist die Abscheidung einer Schicht 12 aus SiOₓ auf der Folie 19 mit einer statischen Abscheidegeschwindigkeit von 800 nm/s. Die Schicht 12 soll hohe Barriereeigenschaften für Sauerstoff und Wasserdampf besitzen. Während des Bedampfungsprozesses treten ähnliche Instabilitäten, wie sie bereits im ersten Ausführungsbeispiel beschrieben wurden, auf.
Mit dieser Einrichtung wird das erfindungsgemäße Verfahren wie folgt ausgeführt. Mittels des Sensors 13 im oberen Teil der Vakuumkammer 1 im Bereich der beschichteten Folie 19 werden die Reflexionsspektren der Schicht 12 in einem Wellenlängenbereich von 180 bis 600 nm aufgenommen. In der Auswerteeinheit 14 werden aus den gemessenen Spektren der Absorptionskoeffizient k und der Brechungsindex n bestimmt und daraus die Barriereeigenschaft der Schicht 12 abgeleitet. Der ermittelte Wert wird dem Regler 15 zugeführt und in diesem mit dem Sollwert verglichen. Der Sollwert wurde experimentell ermittelt und repräsentiert die geforderte Barriereeigenschaft der aufgedampften Siliziumoxidschicht 12 auf der Folie 19. Aus dem Vergleich dieser Werte wird ein Regelsignal gebildet, welches den Reaktivgasfluß mittels der Gaseinlaßeinrichtung 18 regelt. In Abhängigkeit von diesem Regelsignal wird der Reaktivgaspartialdruck beeinflußt. Bei einem Abstand zwischen dem Prozeßraum 5 und dem Bereich, in dem der Sensor 13 angeordnet ist, von ca. 1 m, ergibt sich eine Zeitverzögerung zwischen der Schichtabscheidung und der Eigenschaftsmessung von ca. 250 ms. Diese Anordnung erfordert eine Grundstabilität des Beschichtungsprozesses von > 250 ms. Um dies zu erreichen, wird mit einem weiteren Sensor 16, der im Bereich der Plasmaquelle 8 angeordnet ist, die Intensität des angeregten Plasmas gemessen und mit Hilfe des Plasmagenerators 9 und des integrierten Reglers in bekannter Weise konstant gehalten. Mit der Anwendung dieses Verfahrens wird unter den angegebenen Prozeßbedingungen eine Verbesserung der Barriereeigenschaft gegenüber der unbeschichteten Folie 19 um den Faktor 100 reproduzierbar erreicht.

## Patentansprüche

1. Verfahren zum plasmagestützten reaktiven Elektronenstrahlbedampfen von Substraten mit harten, verschleißfesten Schichten und/oder Schichten mit Barriereeigenschaften durch Erzeugen eines steuerbaren Plasmas im Prozeßraum zwischen dem Verdampfungsgut und dem zu beschichtenden Substrat und in-situ-Messung optischer Eigenschaften, **dadurch gekennzeichnet,** daß unmittelbar nach dem Durchlauf des Substrates durch die Bedampfungszone die Refelexion und/oder Transmission und das Absorptionsvermögen im Wellenlängenbereich Δ_{λ} = 150 nm bis 800 nm gemessen werden, daß daraus der Brechungsindex n und der optische Absorptionskoeffizient k getrennt bestimmt werden, daß diese Werte k und n mit einem experimentell ermittelten Sollwert, der mit bestimmten nichtoptischen Eigenschaften - wie Härte, Abrieb und Barrierewirkung - der aufgebrachten Schicht korreliert, verglichen werden und daß mit dem aus dem Vergleich entstehenden Regelsignal bei konstantem Reaktivgas-Partialdruck die Parameter des Plasmas oder bei konstanten Parametern des Plasmas der Reaktivgas-Partialdruck derart geregelt werden, daß die eingangs gemessenen optischen Eigenschaften der aufgedampften Schicht konstant gehalten werden.

2. Verfahren nach Anspruch 1, **dadurch gekennzeichnet,** daß zur Gewährleistung der Grundstabilität der Quelle zur Plasmaerzeugung die Intensität der Plasmaemission im Prozeßraum gemessen wird und durch Regelung der elektrischen Leistung oder des Gasflusses der Plasmaquelle geregelt wird.

3. Verfahren nach Anspruch 1, **dadurch gekennzeichnet,** daß der Reaktivgas-Partialdruck durch Regelung des Reaktivgas-Flusses geregelt wird.

4. Verfahren nach Anspruch 1, **dadurch gekennzeichnet,** daß der Reaktivgas-Partialdruck durch Regelung des Saugvermögens der Vakuumpumpe geregelt wird.

## Claims

1. A method of plasma-assisted reactive electron beam vapour deposition on substrates of hard, wear-resistant coatings and/or coatings with barrier characteristics, by creating a controllable plasma in the processing space between the vaporising material and the substrate to be coated and in-situ measurement of optical characteristics, characterized in that directly after the passage of the substrate through the vapour deposition zone, the reflection and/or transmission and the absorption power are measured in the wavelength range Δ_{λ} = 150 nm to 800 nm, in that the refractive index n and the optical absorption coefficient k are separately determined therefrom, in that these values k and n are compared with experimentally determined set-point values which are correlated with specific non-optical characteristics - such as hardness, abrasion and barrier effect - and in that the parameters of the plasma are regulated at constant partial pressure of the reactive gas or the partial pressure of the reactive gas is regulated with constant plasma parameters, using the regulating signal resulting from the comparison, in such a way that the optical characteristics of the vapour-deposited coating measured at the beginning are maintained constant.

2. A method according to claim 1, characterized in that the intensity of the plasma emission in the processing space is measured and the plasma source is regulated by regulating the electric power or the gas flow in order to ensure basic stability of the plasma generation source.

3. A method according to claim 1, characterized in that the partial pressure of the reactive gas is regulated by regulating the reactive gas flow.

4. A method according to claim 1, characterized in that the partial pressure of the reactive gas is regulated by regulating the degree of suction of the vacuum pump.

## Revendications

1. Procédé de vaporisation réactif par jet électronique, assistée par plasma de substrats avec des couches dures, résistant à l'abrasion et/ou des couches ayant des propriétés de barrière, par production d'un plasma commandable dans la chambre du procédé entre la matière de vaporisation et le substrat à enduire et par mesure in situ des propriétés optiques,
caractérisé en ce qu'
on mesure directement après le passage du substrat à travers la zone de vaporisation la réflexion et/ou la transmission et le pouvoir d'absorption dans le domaine de longueurs d'ondes Δ_{λ} = 150 nm jusqu'à 800 nm, en ce qu'à partir de là, on détermine l'indice de réfraction n et le coefficient d'absorption technique k séparément, en ce que ces valeurs k et n sont comparées avec une valeur de consigne, déterminée expérimentalement, qui est en corrélation avec des propriétés non optiques déterminées, comme la dureté, l'abrasion et l'effet barrière de la couche appliquée et, qu'avec le signal de réglage naissant de la comparaison dans le cas d'une pression partielle constante de-gaz réactif, les paramètres du plasma ou, dans le cas de paramètres constants du plasma, la pression partielle du gaz de réaction sont régulés, de sorte que les propriétés optiques mesurées au début de la couche vaporisée sont maintenues constantes.

2. Procédé selon la revendication 1,
caractérisé en ce que
pour garantir la stabilité de base de la source de production de plasma, on mesure l'intensité de l'émission de plasma dans la chambre du procédé et on la règle par régulation de la puissance électrique ou du flux de gaz de la source de plasma.

3. Procédé selon la revendication 1,
caractérisé en ce que
la pression partielle du gaz réactif est réglée par la régulation du flux de gaz réactif.

4. Procédé selon la revendication 1,
caractérisé en ce que
la pression partielle du gaz réactif est réglée par la régulation du pouvoir d'aspiration de la pompe à vide.
